# EUROPEAN PATENT SPECIFICATION

(11) **EP 2 492 588 B1**
(45) Date of publication and mention of the grant of the patent: **12.08.2015**
(21) Application number: 12156457.9
(22) Date of filing: 22.02.2012
(51) Int. Cl.: F21V 27/02, F21V 19/00, H01R 13/58, F21Y 101/02, F21Y 113/00

(54) **Solid state lighting assembly having a strain relief member**
Festkörperbeleuchtungsanordnung mit Zugentlastungselement
Ensemble d'éclairage d'état solide doté d'un élément de réduction de tension

(30) Priority: 25.02.2011 US 201113035513
(43) Date of publication of application: 29.08.2012
(73) Proprietor: Tyco Electronics Corporation, Berwyn, PA 19312 (US)
(72) Inventor: Mostoller, Matthew Edward, Hummelstown, PA 17036 (US); Daily, Christopher George, Harrisburg, PA 17111 (US)
(74) Representative: Johnstone, Douglas Ian

(56) References cited:
- WO-A1-2004/048846
- CA-A1- 2 622 170
- US-A1- 2009 027 900

## Description

The subject matter described herein relates generally to solid state lighting assemblies.

Solid state lighting assemblies generally include a solid state lighting module having a substrate with a lighting element disposed thereon. For example, the lighting element may be a light emitting diode (LED). The substrate includes contacts pads that are electrically coupled to the lighting element. The contact pads include a positive contact pad and a negative contact pad. The positive contact pad and the negative contact pad are configured to electrically couple to a positive wire and a negative wire, respectively. The positive wire and the negative wire form a circuit through the solid state lighting module to power the lighting element.

However, conventional solid state lighting assemblies are not without their disadvantages. Typically, the wires (positive and negative) are soldered to the contact pads of the substrate. Soldering the wires to the contact pads generally requires special tools, extra materials, and an extra assembly step, which add to the overall cost of assembly. Additionally, soldering, over time and with handling of the components, may subject the assembly to improper electrical connections. Moreover, the soldered wires may be subject to becoming dislodged from the contact pads of the substrate. In particular, forces applied to the wires may disconnect the wires from the contact pad.

US 2009/0027900, on which the preamble of claim 1 is based, discloses a solid state lighting assembly comprising a housing configured to hold a circuit board which carries LEDs wherein the circuit board is connected by wiring to an external power source. Screws are used to attach a back to the housing and the screws can provide strain relief for the wiring.

The problem to be solved is a need remains for a solid state lighting assembly that enables quick and tool-less connections between the wires and the contact pads. Another need remains for a solid state lighting assembly that provides strain relief for the wires to prevent the wires from becoming disconnected from the contact pads.

The solution is provided by a solid state lighting assembly comprising: a housing configured to hold a solid state lighting module, the housing having a cavity; a wire extending from the cavity to an exterior of the housing; and a strain relief member extending from the exterior of the housing, the strain relief member configured to engage a portion of the wire, characterized in that the solid state lighting assembly includes a contact positioned within the cavity, the contact having a wire end and a mating end, the wire end configured to be coupled to an insertion segment of the wire, and the strain relief member is configured to engage a portion of the wire upstream from the insertion segment of the wire.

The invention will now be described by way of example with reference to the accompanying drawings in which:
Figure 1 is a top perspective view of a solid state lighting assembly formed in accordance with an embodiment.
Figure 2 is a bottom perspective view of the solid state lighting assembly shown in Figure 1.
Figure 3 is a top perspective view of a solid state lighting module formed in accordance with an embodiment.
Figure 4 is a partial top perspective view of the solid state lighting assembly shown in Figure 1.
Figure 5 is a partial cut-away view of the solid state lighting assembly shown in Figure 1.
Figure 6 is a top perspective view of a strain relief member formed in accordance with an embodiment.
Figure 7 is a top perspective view of a strain relief member formed in accordance with another embodiment.
Figure 8 is a top perspective view of a strain relief member formed in accordance with another embodiment.
Figure 9 is a top perspective view of the solid state lighting assembly shown in Figure 1 and having an optic formed in accordance with an embodiment and coupled thereto.

A solid state lighting assembly is provided and includes a housing configured to hold a solid state lighting module. The housing has a cavity. A contact is positioned within the cavity. The contact has a wire end and a mating end. The wire end is configured to be coupled to an insertion segment of a wire. The wire extends from the cavity to an exterior of the housing. A strain relief member extends from the exterior of the housing. The strain relief member is configured to engage a portion of the wire upstream from the insertion segment of the wire.

The housing cavity may have a cavity axis. The wire end of the contact may be formed as a poke-in wire connection having a barrel extending axially along the cavity axis and a barb extending into the barrel at an oblique angle with respect to the cavity axis. The barb may engage a conductor of the insertion segment of the wire which may be inserted into the barrel in a loading direction. The barb retains the insertion segment of the wire in the barrel in response to forces applied to the wire in a direction opposite to the loading direction

The foregoing summary, as well as the following detailed description of certain embodiments will be better understood when read in conjunction with the appended drawings. As used herein, an element or step recited in the singular and proceeded with the word "a" or "an" should be understood as not excluding plural of said elements or steps, unless such exclusion is explicitly stated.

Embodiments described herein include a solid state lighting assembly having a tool-less connection between the wires and the contact pads of a solid state lighting module. The embodiments include a poke-in wire connection that receives wires configured to power a lighting element of the solid state lighting assembly. The poke-in wire connection includes a contact having a wire end that receives the wire and mating end that forms a separable, compressible interface with the contact pads of the solid state lighting module. The wire end of the contact includes a barb that engages the wire to oppose forces that may dislodge the wire from the contact. Additionally, the solid state lighting assembly includes a strain relief member configured to engage the wire. The strain relief member further opposes forces that may dislodge the wire from the contact.

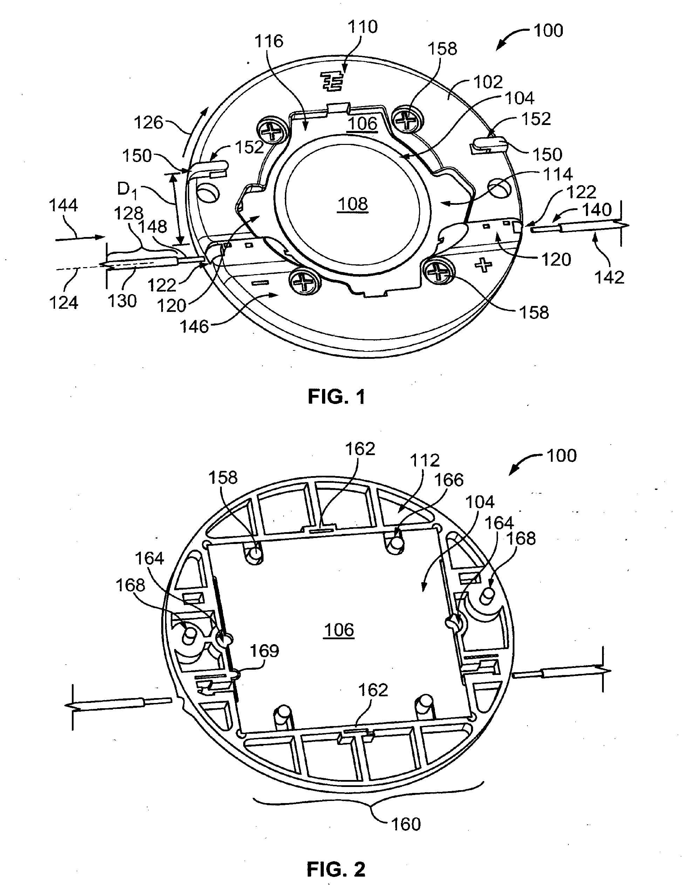

Figure 1 is a top perspective view of a solid state lighting assembly 100 formed in accordance with an embodiment. The solid state lighting assembly 100 includes a housing 102 and a solid state lighting module 104. The solid state lighting module 104 includes a substrate 106 having a lighting element 108 disposed thereon. In an exemplary embodiment, the lighting element 108 may be a light emitting diode (LED) or any other suitable solid state lighting element. The housing 102 includes a top 110 and an opposite bottom 112 (shown in Figure 2). An opening 114 extends through the housing 102 from the top 110 to the bottom 112. The opening 114 is generally centered within the housing 102. Alternatively, the opening 114 may extend through any portion of the housing 102.

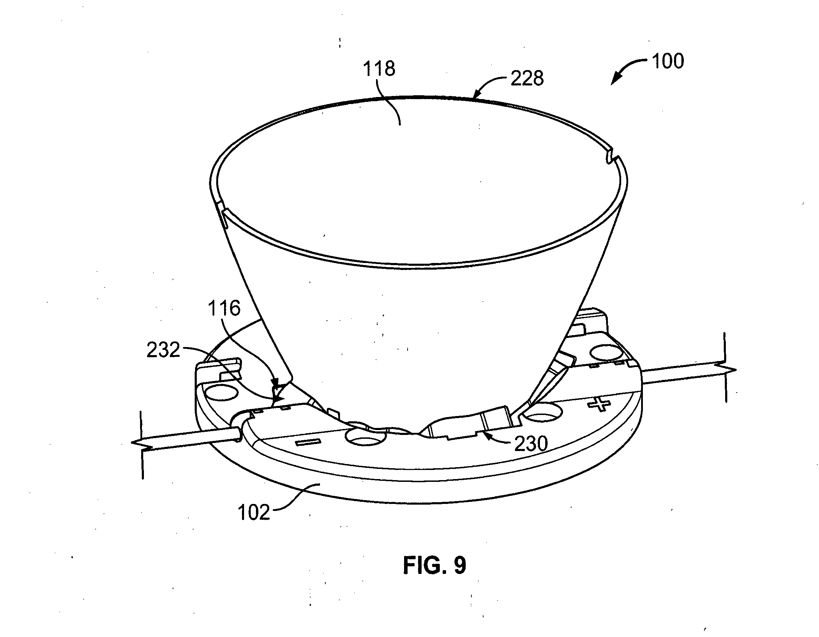

The substrate 106 of the solid state lighting module 104 is received in the bottom 112 of the housing 102. The substrate 106 is received in the housing 102 such that the lighting element 108 is positioned within the opening 114 of the housing 102. In one embodiment, the lighting element 108 may extend through the opening 114 of the housing 102. The lighting element 108 emits light from the top 110 of the housing 102. In the illustrated embodiment, the housing 102 includes recesses 116 formed around the opening 114. The recesses 116 may be configured to receive an optic 118, as illustrated in Figure 9. The optic 118 directs the light emitted from the lighting element 108 in a particular lighting pattern.

Cavities 120 are formed in the housing 102. The cavities 120 include an opening 122. The cavities 120 extend from the opening 122 into the housing 102. The cavities 120 extend along a cavity axis 124 from the opening 122 into the housing 102. The openings 122 of the cavities 120 may be formed proximate to an outer perimeter 126 of the housing 102. In alternative embodiments, the openings 122 of the cavities 120 may be formed inward from the perimeter 126 of the housing 102. For example, the openings 122 of the cavities 120 may be formed proximate to the opening 114 of the housing 102. The openings 122 of the cavities 120 face away from the opening 114 of the housing 102. The openings 122 of the cavities 120 may face toward the opening 114 of the housing 102 or at any suitable angle with respect to the opening 114 of the housing in alternative embodiments.

The openings 122 of the cavities 120 are configured to receive a insertion segment 128 of a wire 130 therein. The insertion segment 128 of the wire 130 may include an exposed conductor 148 that is terminated within the cavity 120. The insertion segment 128 of the wire 130 is inserted into the cavity 120 along the cavity axis 124 in a loading direction 144. The wire 130 extends from the cavity 120 to an exterior 146 of the housing 102. The illustrated embodiment includes a positive cavity 120 and a negative cavity 120. The positive cavity 120 receives a positive wire 130 having a positive polarity. The negative cavity 120 receives a negative wire 130 having negative polarity. In the illustrated embodiment, the opening 122 of the positive cavity 120 faces in a different direction than the opening 122 of the negative cavity 120. For example, the opening 122 of the positive cavity 120 is illustrated facing in an opposite direction from the opening 122 of the negative cavity 120. Optionally, the opening 122 of the positive cavity 120 and the opening 122 of the negative cavity 120 may face in other directions, including in the same direction.

In an exemplary embodiment, the wire 130 includes a downstream end 140 and an upstream end 142. The insertion segment 128 of the wire 130 is positioned at the downstream end 140 of the wire 130. The downstream end 140 of the wire 130 is received in the cavity 120. The upstream end 142 of the wire 130 extends from the housing 102 to another component, such as a driver or a power source (not shown).

A strain relief member 150 extends from the exterior 146 of the housing 102. The strain relief member 150 may be coupled to the housing 102. In other embodiments the strain relief member 150 may be formed integrally with the housing 102. The strain relief member 150 is positioned spaced apart from the cavity 120. For example, the strain relief member 150 and the cavity 120 may be spaced apart a distance D₁. In the illustrated embodiment, the strain relief member 150 is positioned proximate to the perimeter 126 of the housing 102. The strain relief member 150 may be positioned inward from the perimeter 126 of the housing 102 in alternative embodiments. For example, the strain relief member 150 may be positioned proximate to the opening 114 of the housing 102.

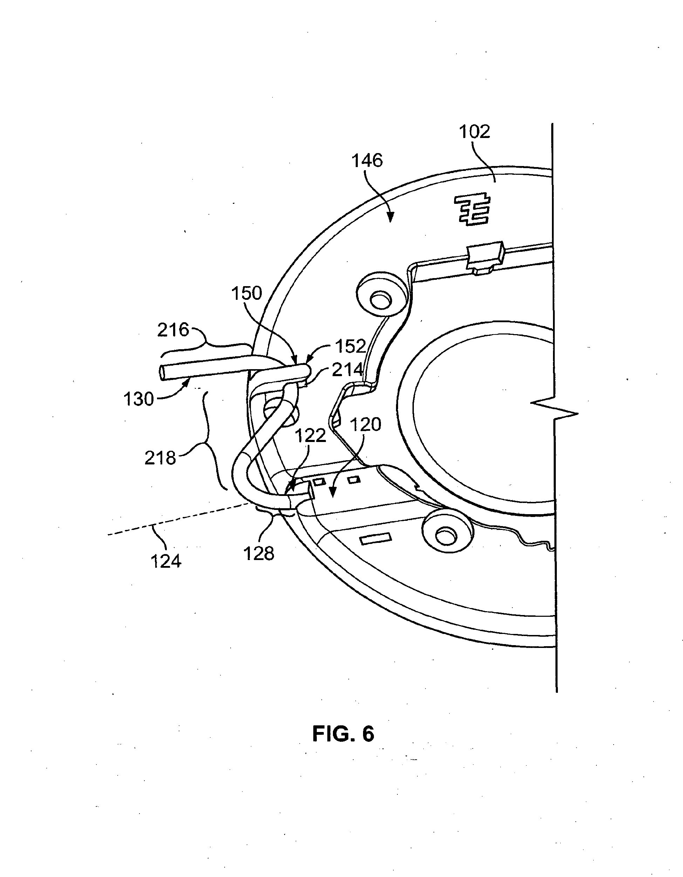

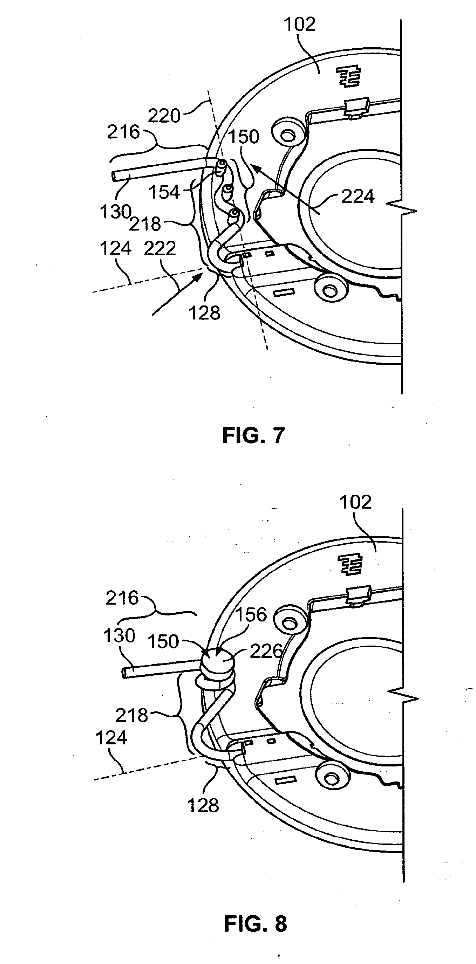

The strain relief member 150 is configured to engage a portion of the wire 130. The strain relief member 150 engages the wire 130 upstream from the insertion segment 128 of the wire 130. The strain relief member 150 provides resistance to forces applied to the wire 130. For example, the strain relief member 150 provides resistance to forces that may tend to disengage the insertion segment 128 of the wire 130 from the cavity 120. The strain relief member 150 may resist forces on the wire 130 in a direction opposite to the loading direction 144 of the wire 130. In the illustrated embodiment, the strain relief member 150 is a hook 152 (as described in more detail with respect to Figure 6). In other embodiments, the strain relief member 150 may be a series of posts 154 (as described in more detail with respect to Figure 7) or a single post 156 (as described in more detail with respect to Figure 8). Alternatively, the strain relief member 150 may be any suitable member for resisting forces on the wire 130.

In the exemplary embodiment, a plurality of screws 158 extend through the housing 102 to secure the housing 102 to a heat sink (not shown).

Figure 2 is a bottom perspective view of the solid state lighting assembly 100. The solid state lighting assembly 100 includes a bottom 112. A solid state lighting module receptacle 160 is formed on the bottom 112 of the solid state lighting assembly 100. The receptacle 160 is sized to receive the substrate 106 of the solid state lighting module 104. The solid state lighting module 104 may be press-fit into the receptacle 160. In an exemplary embodiment, the receptacle 160 includes retention mechanisms 162 to create an interference fit with the solid state lighting module 104. Alternatively, the receptacle 160 may include latches, grooves, notches, and/or any other suitable mechanism for securing the solid state lighting module 104 to the housing 102. In one embodiment, the solid state lighting module 104 may be adhered or bonded to the housing 102. Recesses 164 may be formed in the receptacle 160 to enable the solid state lighting module 104 to be removed from the housing 102. In an alternative embodiment, the solid state lighting module 104 may be secured to the heat sink and the housing 102 may be loaded over the solid state lighting module 104.

The screws 158 extend through the bottom 112 of the housing 102. The screws 158 are configured to couple the housing 102 to the heat sink (not shown), such that the solid state lighting module 104 is secured between the heat sink and the housing 102. The screws 158 extend through mounting locations 166 formed in the substrate 106 such that the screws 158 are not secured to the substrate 106. Alternatively, the screws 158 may be secured to the substrate 106. In other embodiments, the housing 102 may include pins, posts, or the like extending therefrom to secure the housing 102 to the heat sink. In the illustrated embodiment, the housing 102 also includes polarization features 169 to provide a keying mechanism for mounting the solid state lighting module 104 within the housing 102. Other polarization features 168 provide an alignment mechanism for mounting the solid state lighting assembly 100 to the heat sink.

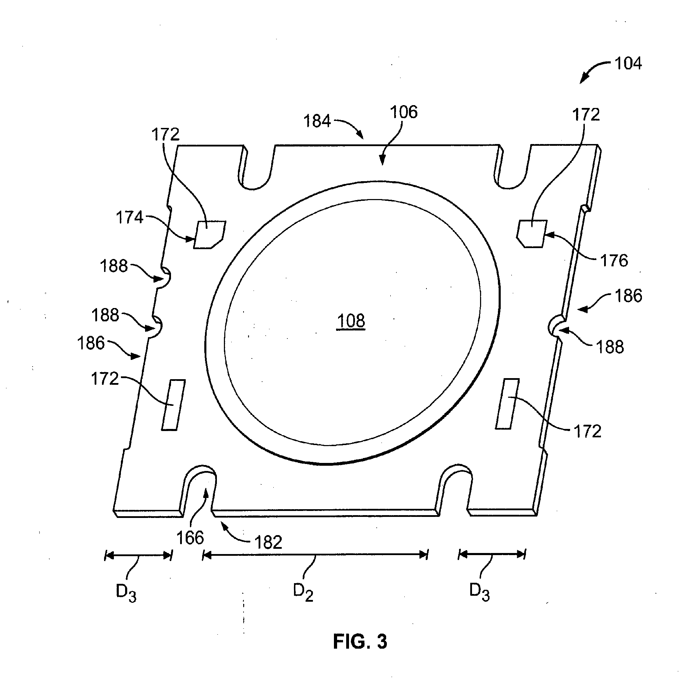

Figure 3 is a top perspective view of the solid state lighting module 104. The solid state lighting module 104 includes the substrate 106. The substrate 106 may be a circuit board, for example, a printed circuit board. The lighting element 108 is centered on the substrate 106. Alternatively, the lighting element 108 may be positioned at any suitable location on the substrate 106. As set forth above, the lighting element 108 may be a solid state lighting element, for example, an LED. The substrate 106 may include a single lighting element 108. In alternative embodiments, the substrate 106 may include multiple lighting elements 108. The multiple lighting elements 108 may include different colored lighting elements 108 so that a color of light emitted from the solid state lighting module 104 may be selectively adjusted and/or adjusted in a lighting sequence. In one embodiment, the lighting element 108 may be covered with a lens or the like.

Contact pads 172 are provided on the substrate 106. The contact pads 172 are electrically conductive and configured to receive a power signal. In an exemplary embodiment, the contact pads 172 are configured to electrically couple to the conductor 148 of a wire 130 (both shown in Figure 1). The contact pads 172 are electrically coupled to the lighting element 108 through a signal trace or the like. The contact pads 172 direct the power signal from a wire 130 to the lighting element 108. The illustrated embodiment includes a positive contact pad 174 and a negative contact pad 176. The positive contact pad 174 is configured to electrically couple to the positive wire 130 (shown in Figure 1). The negative contact pad 176 is configured to electrically couple to the negative wire 130 (shown in Figure 1).

The substrate 106 includes a front 182 and a back 184. A pair of sides 186 extends between the front 182 and the back 184. The mounting locations 166 are formed in the front 182 and the back 184 of the substrate 106. Alternatively, the mounting locations 166 may be formed in the sides 186 of the substrate 106. Each of the front 182 and the back 184 of the substrate 106 includes a pair of mounting locations 166 separated by a distance D₂. Each of the pair of mounting locations 166 is positioned a distance D₃ from the sides 186 of the substrate 106. In other embodiments, each of the front 182 and the back 184 of the substrate 106 may include any number of mounting locations 166 spaced at any distance D₂ from each other or distance D₃ from the sides 186 of the substrate 106. The screws 158 (shown in Figure 1) are configured to extend through the mounting locations 166. In one embodiment, the screws 158 may be secured to the substrate 106 at the mounting locations 166.

The sides 186 of the substrate 106 include polarization recesses 188 formed therein. Optionally, polarization recesses 188 may be formed in the front 182 and/or back 184 of the substrate 106. The polarization recesses 188 are configured to receive the polarization features 169 of the housing 102 therethrough.

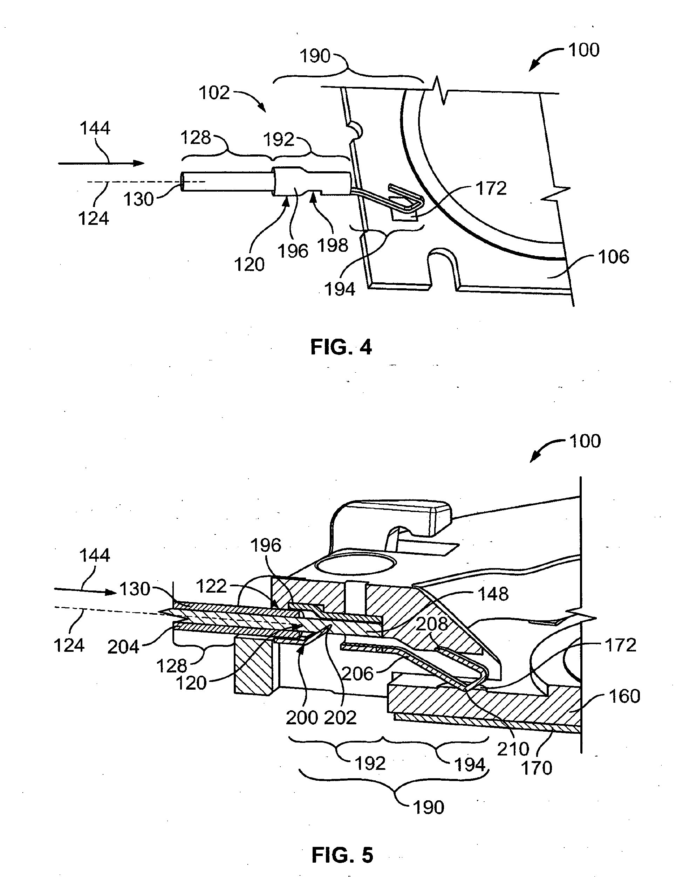

Figure 4 is a partial top perspective view of the solid state lighting assembly 100. The housing 102 of the solid state lighting assembly 100 is illustrated in phantom to show an interior 198 of the cavity 120. A contact 190 is positioned within the cavity 120. In the illustrated embodiment, the contact 190 is a poke-in wire contact configured to receive the conductor 148 of the wire 130. The contact 190 may be an insulation displacement connector, a crimp connector, or the like in alternative embodiments. In the illustrated embodiment, the contact 190 includes a wire end 192 and a mating end 194. The mating end 194 of the contact 190 forms a separable, compressible interface with the contact pad 172 of the substrate 106.

The wire end 192 of the contact 190 includes a barrel 196 that receives the conductor 148 of the wire 130. The barrel 196 extends through the cavity 120 along the cavity axis 124. The conductor 148 of the wire 130 is inserted into the barrel 196 in the loading direction 144.

Figure 5 is a partial cut-away view of the solid state lighting assembly 100. The wire end 192 of the contact 190 includes the barrel 196 and a barb 200. The barrel 196 extends from the opening 122 of the cavity 120 into the cavity 120 along the cavity axis 124. The barb 200 extends at an oblique angle with respect to the cavity axis 124. As used herein, the term "oblique angle" is defined as any angle that diverges from a straight line. An "oblique angle" may be an acute angle, an obtuse angle, or a right angle. The barb 200 extends inward from the barrel 196 in the direction of the loading direction 144. When the insertion segment 128 of the wire 130 is inserted into the barrel 196, a tip 202 of the barb 200 engages the wire 130. In one embodiment, the tip 202 of the barb 200 engages the conductor 148 of the wire 130. The barb 200 retains the wire 130 in the barrel 196. The barb 200 is configured to oppose forces applied to the wire 130 in a direction opposite to the loading direction 144 of the wire 130.

The conductor 148 of the wire 130 engages the wire end 192 of the contact 190. The mating end 194 of the contact 190 extends from the wire end 192 of the contact 190 such that power signals from the wire 130 are directed to the mating end 194 of the contact 190. In the illustrated embodiment, the mating end 194 of the contact 190 extends from the barrel 196. The mating end 194 of the contact 190 is configured as a simply supported beam. The mating end 194 of the contact 190 includes a transition member 206 that is joined to the wire end 192 of the contact 190. A tip 208 of the mating end 194 of the contact 190 abuts the housing 102. A mating interface 210 of the mating end 194 of the contact 190 extends between the tip 208 and the transition member 206.

The mating interface 210 is configured to engage the contact pad 172 of the substrate 106. The mating interface 210 forms separable, compressible interface with the contact pad 172 of the substrate 106. The contact 190 is flexed between the tip 208 of the mating end 194 and the mating interface 210 to spring bias the contact 190 against the contact pad 172.

In the illustrated embodiment, the thermal interface 170 is provided on the substrate 106. The thermal interface 170 may be any suitable thermal interface, for example conductive grease, for mounting the substrate 106 to a heat sink (not shown).

Figure 6 is a top perspective view of a strain relief member 150 formed in accordance with an embodiment and having the wire 130 coupled thereto. Figure 6 illustrates the strain relief member 150 as a hook 152. The hook 152 is provided on the exterior 146 of the housing 102. The hook 152 may be coupled to the housing 102 or formed integrally therewith. The hook 152 includes a slot 214 to engage the wire 130 upstream from the insertion segment 128 of the wire 130. The wire 130 at least partially extends around the hook 152. The slot 214 may be sized to form an interference fit with the wire 130. In the illustrated embodiment, the slot 214 faces in a different direction than the opening 122 of the cavity 120. The slot 214 faces in an opposite direction from the opening 122 of the cavity 120. Optionally, the slot 214 and the opening 122 of the cavity 120 may face in the same direction.

The wire 130 includes the insertion segment 128 extending from the cavity 120 to the exterior 146 of the housing 102. The insertion segment 128 generally extends along the cavity axis 124 of the cavity 120. A main segment 216 of the wire extends from the hook 152 to a power source (not shown). An intermediate segment 218 of the wire 130 extends between the main segment 216 of the wire 130 and the insertion segment 128 of the wire 130. The hook 152 engages the wire 130 such that the intermediate segment 218 of the wire 130 extends at an oblique angle with respect to the cavity axis 124. The hook 152 engages the wire 130 such that the main segment 216 of the wire 130 extends at an oblique angle with respect to the intermediate segment 218 of the wire 130. The main segment 216 of the wire 130 may extend from the hook 152 parallel to the cavity axis 124. Optionally, the main segment 216 of the wire 130 may extend from the hook 152 at an oblique angle with respect to the cavity axis 124.

Figure 7 is a top perspective view of a strain relief member 150 formed in accordance with an embodiment and having the wire 130 coupled thereto. Figure 7 illustrates the strain relief member 150 as a series of posts 154. The posts 154 extend along a line 220. The illustrated embodiment includes three posts 154. Alternative embodiments may include any number of posts 154. The intermediate segment 218 of the wire 130 is threaded through the posts 154 such that intermediate segment 218 of the wire 130 changes directions at each post 154. For example, the intermediate segment 218 of the wire 130 travels in a first direction 222 to a first post 154 and travels in a second direction 224 from the first post 154 to a second post 154. The intermediate segment 218 of the wire 130 at least partially wraps around each post 154. Optionally, the intermediate segment 218 of the wire 130 may be entirely wrapped around each post 154 one or more times.

In one embodiment, the posts 154 may include a flange (not shown) extending from the top thereof. The intermediate segment 218 of the wire 130 may be held between the housing 102 and the flange. The flange may form an interference fit with the wire 130. In another embodiment, the posts 154 may include grooves extending therearound to receive and position the intermediate segment 218 of the wire 130 with respect to the post 154.

The posts 154 engage the wire 130 such that the intermediate segment 218 of the wire 130 extends at an oblique angle with respect to the cavity axis 124. The posts 154 engage the wire 130 such that the main segment 216 of the wire 130 extends at an oblique angle with respect to the intermediate segment 218 of the wire 130. The main segment 216 of the wire 130 may extend from the last post 154 parallel to the cavity axis 124. Optionally, the main segment 216 of the wire 130 may extend from the last post 154 at an oblique angle with respect to the cavity axis 124.

Figure 8 is a top perspective view of a strain relief member 150 formed in accordance with an embodiment and having the wire 130 coupled thereto. Figure 8 illustrates the strain relief member 150 as a post 156. The post 156 may be integrally formed with the housing 102. Alternatively, the post 156, may be a screw, pin, or the like that is inserted into the housing 102. The wire 130 is configured to wrap at least partially around the post 156. Optionally, the wire 130 may be wrapped entirely around the post 156 one or more times.

In the illustrated embodiment, the post 156 includes a flange 226 extending from the top thereof. The intermediate segment 218 of the wire 130 may be held between the housing 102 and the flange 226. The flange 226 may form an interference fit with the wire 130. In another embodiment, the post 156 may include grooves extending therearound to receive and position the intermediate segment 218 of the wire 130 with respect to the post 156.

The post 156 engages the wire 130 such that the intermediate segment 218 of the wire 130 extends at an oblique angle with respect to the cavity axis 124. The post 156 engages the wire 130 such that the main segment 216 of the wire 130 extends at an oblique angle with respect to the intermediate segment 218 of the wire 130. The main segment 216 of the wire 130 may extend from the post 156 parallel to the cavity axis 124. Optionally, the main segment 216 of the wire 130 may extend from the post 156 at an oblique angle with respect to the cavity axis 124.

Figure 9 is a top perspective view of the solid state lighting assembly 100 having an optic 118 coupled thereto. The optic 118 includes a top 228 and a bottom 230. The bottom 230 of the optic 118 is coupled to the housing 102 of the solid state lighting assembly 100. The bottom 230 of the optic 118 includes protrusions 232 extending therefrom. The protrusions 232 are received in the recesses 116 of the housing 102. The protrusions 232 may be press-fit into the recesses 116 and/or retained within the recesses 116 through an interference fit. In one embodiment, the housing 102 may include a latch, detent, or the like to retain the optic 118. Optionally, the optic 118 may be adhered or bonded to the housing 102 or substrate 106.

The optic 118 has a conical shape and extends outward from the bottom 230 of the optic 118 to the top 228 of the optic 118. The optic 118 is configured to direct and/or focus light emitted from the solid state lighting assembly 100.

## Claims

1. A solid state lighting assembly (100) comprising: a housing (102) configured to hold a solid state lighting module (104), the housing (102) having a cavity (120); a wire (130) extending from the cavity (120) to an exterior (146) of the housing (102); and a strain relief member (150) extending from the exterior (146) of the housing (102), the strain relief member (150) configured to engage a portion of the wire (130), **characterized in that**
the solid state lighting assembly (100) includes a contact (190) positioned within the cavity (120), the contact (190) having a wire end (192) and a mating end (194), the wire end (192) configured to be coupled to an insertion segment (128) of the wire (130), and
the strain relief member (150) is configured to engage a portion of the wire (130) upstream from the insertion segment (128) of the wire (130).

2. The solid state lighting assembly (100) of claim 1, wherein the cavity (120) extends along a cavity axis (124), the insertion segment (128) of the wire (130) extending along the cavity axis (124) to the contact (190), the strain relief member (150) being positioned spaced apart from the cavity (120) such that an intermediate segment (218) of the wire (130) extends between the cavity (120) and the strain relief member (150) at an oblique angle with respect to the cavity axis (124).

3. The solid state lighting assembly (100) of claim 1 or 2, wherein an intermediate segment (218) of the wire (130) extends between the insertion segment (128) of the wire and a main segment (216) of the wire (130), the strain relief member (150) holding the wire (130) such that the main segment (216) of the wire (130) extends from the intermediate segment (218) of the wire (130) at an oblique angle.

4. The solid state lighting assembly (100) of any preceding claim, wherein the strain relief member (150) is a hook (152) that receives the wire (130) such that the wire (130) wraps at least partially around the hook (152).

5. The solid state lighting assembly (100) of claim 4, wherein the hook (152) includes a slot (214) to receive the wire and the cavity (120) includes an opening (122) to receive the insertion segment (128) of the wire (130), the opening (122) of the cavity (120) and the slot (214) of the hook (152) facing in different directions.

6. The solid state lighting assembly (100) of any of claims 1 to 3, wherein the strain relief member (150) is a post (156), the wire (130) being wrapped at least one time around the post (156).

7. The solid state lighting assembly (100) of any of claims 1 to 3, wherein the strain relief member (150) includes a series of posts (154), the wire (130) being threaded through the series of posts (154) such that the wire (130) changes directions between each post (154).

8. The solid state lighting assembly (100) of any preceding claim, wherein the contact (190) is configured to be terminated to the insertion segment (128) of the wire (130) by one of a poke-in contact, insulation displacement connectors, or a crimp connection.

## Patentansprüche

1. Festkörperbeleuchtungsanordnung (100), die aufweist: ein Gehäuse (102), das ausgebildet ist, um ein Festkörperbeleuchtungsmodul (104) aufzunehmen, wobei das Gehäuse (102) einen Hohlraum (120) aufweist; einen Draht (130), der sich vom Hohlraum (120) zu einer Außenseite (146) des Gehäuses (102) erstreckt; und ein Zugentlastungselement (150), das sich von der Außenseite (146) des Gehäuses (102) erstreckt, wobei das Zugentlastungselement (150) ausgebildet ist, um mit einem Abschnitt des Drahtes (130) in Eingriff zu kommen, **dadurch gekennzeichnet, dass**
die Festkörperbeleuchtungsanordnung (100) einen Kontakt (190) umfasst, der innerhalb des Hohlraumes (120) positioniert ist, wobei der Kontakt (190) ein Drahtende (192) und ein Eingriffsende (194) aufweist, wobei das Drahtende (192) ausgebildet ist, um mit einem Einsetzsegment (128) des Drahtes (130) verbunden zu werden, und dass
das Zugentlastungselement (150) ausgebildet ist, um mit einem Abschnitt des Drahtes (130) vor dem Einsetzsegment (128) des Drahtes (130) in Eingriff zu kommen.

2. Festkörperbeleuchtungsanordnung (100) nach Anspruch 1, bei der sich der Hohlraum (120) längs einer Hohlraumachse (124) erstreckt, sich das Einsetzsegment (128) des Drahtes (130) längs der Hohlraumachse (124) zum Kontakt (190) erstreckt, wobei das Zugentlastungselement (150) beabstandet vom Hohlraum (120) positioniert ist, so dass sich ein Zwischensegment (218) des Drahtes (130) zwischen dem Hohlraum (120) und dem Zugentlastungselement (150) unter einem schiefen Winkel mit Bezugnahme auf die Hohlraumachse (124) erstreckt.

3. Festkörperbeleuchtungsanordnung (100) nach Anspruch 1 oder 2, bei der sich ein Zwischensegment (218) des Drahtes (130) zwischen dem Einsetzsegment (128) des Drahtes und einem Hauptsegment (216) des Drahtes (130) erstreckt, wobei das Zugentlastungselement (150) den Draht (130) so aufnimmt, dass sich das Hauptsegment (216) des Drahtes (130) vom Zwischensegment (218) des Drahtes (130) unter einem schiefen Winkel erstreckt.

4. Festkörperbeleuchtungsanordnung (100) nach einem der vorhergehenden Ansprüche, bei der das Zugentlastungselement (150) ein Haken (152) ist, der den Draht (130) aufnimmt, so dass sich der Draht (130) mindestens teilweise um den Haken (152) herum wickelt.

5. Festkörperbeleuchtungsanordnung (100) nach Anspruch 4, bei der der Haken (152) einen Schlitz (214) umfasst, um den Draht aufzunehmen, und wobei der Hohlraum (120) eine Öffnung (122) umfasst, um das Einsetzsegment (128) des Drahtes (130) aufzunehmen, wobei die Öffnung (122) des Hohlraumes (120) und der Schlitz (214) des Hakens (152) in verschiedenen Richtungen liegen.

6. Festkörperbeleuchtungsanordnung (100) nach einem der Ansprüche 1 bis 3, bei der das Zugentlastungselement (150) ein Stift (156) ist, wobei der Draht (130) mindestens einmal um den Stift (156) herum gewickelt wird.

7. Festkörperbeleuchtungsanordnung (100) nach einem der Ansprüche 1 bis 3, bei der das Zugentlastungselement (150) eine Reihe von Stiften (154) umfasst, wobei der Draht (130) durch die Reihe der Stifte (154) gefädelt wird, so dass der Draht (130) seine Richtung zwischen einem jeden Stift (154) verändert.

8. Festkörperbeleuchtungsanordnung (100) nach einem der vorhergehenden Ansprüche, bei der der Kontakt (190) so ausgebildet ist, dass er am Einsetzsegment (128) des Drahtes (130) mittels eines von einem Steckkontakt, Schneidklemmverbindern oder einer Crimpverbindung angeschlossen wird.

## Revendications

1. Ensemble d'éclairage à semi-conducteurs (100) comprenant : un boîtier (102) configuré pour contenir un module d'éclairage à semi-conducteurs (104), le boîtier (102) présentant une cavité (120) ; un fil électrique (130) s'étendant à partir de la cavité (120) vers un extérieur (146) du boîtier (102) ; et un élément formant serre-câble (150) s'étendant à partir de l'extérieur (146) du boîtier (102), l'élément formant serre-câble (150) étant configuré pour mettre en prise une partie du fil électrique (130), **caractérisé en ce que**
l'ensemble d'éclairage à semi-conducteurs (100) comprend un contact (190) positionné au sein de la cavité (120), le contact (190) présentant une extrémité fil électrique (192) et une extrémité homologue (194), l'extrémité fil électrique (192) étant configurée pour être couplée à un segment d'insertion (128) du fil électrique (130), et
l'élément formant serre-câble (150) est configuré pour mettre en prise une partie du fil électrique (130) en amont du segment d'insertion (128) du fil électrique (130).

2. Ensemble d'éclairage à semi-conducteurs (100) selon la revendication 1, dans lequel la cavité (120) s'étend le long d'un axe de cavité (124), le segment d'insertion (128) du fil électrique (130) s'étendant le long de l'axe de cavité (124) vers le contact (190), l'élément formant serre-câble (150) étant positionné espacé par rapport à la cavité (120) de telle manière qu'un segment intermédiaire (218) du fil électrique (130) s'étend entre la cavité (120) et l'élément formant serre-câble (150) selon un angle oblique par rapport à l'axe de cavité (124).

3. Ensemble d'éclairage à semi-conducteurs (100) selon la revendication 1 ou 2, dans lequel un segment intermédiaire (218) du fil électrique (130) s'étend entre le segment d'insertion (128) du fil électrique et un segment principal (216) du fil électrique (130), l'élément formant serre-câble (150) retenant le fil électrique (130) de telle manière que le segment principal (216) du fil électrique (130) s'étend à partir du segment intermédiaire (218) du fil électrique (130) selon un angle oblique.

4. Ensemble d'éclairage à semi-conducteurs (100) selon l'une quelconque des revendications précédentes, dans lequel l'élément formant serre-câble (150) est un crochet (152) qui reçoit le fil électrique (130) de telle manière que le fil électrique (130) s'enroule au moins partiellement autour du crochet (152).

5. Ensemble d'éclairage à semi-conducteurs (100) selon la revendication 4, dans lequel le crochet (152) comprend un évidement (214) pour recevoir le fil électrique et la cavité (120) comprend une ouverture (122) pour recevoir le segment d'insertion (128) du fil électrique (130), l'ouverture (122) de la cavité (120) et l'évidement (214) du crochet (152) regardant dans des directions différentes.

6. Ensemble d'éclairage à semi-conducteurs (100) selon l'une quelconque des revendications 1 à 3, dans lequel l'élément formant serre-câble (150) est un piton (156), le fil électrique (130) étant enroulé au moins une fois autour du piton (156).

7. Ensemble d'éclairage à semi-conducteurs (100) selon l'une quelconque des revendications 1 à 3, dans lequel l'élément formant serre-câble (150) comprend une série de pitons (154), le fil électrique (130) étant faufilé à travers la série de pitons (154) de telle manière que le fil électrique (130) change de direction entre chaque piton (154).

8. Ensemble d'éclairage à semi-conducteurs (100) selon l'une quelconque des revendications précédentes, dans lequel le contact (190) est configuré pour se terminer au niveau du segment d'insertion (128) du fil électrique (130) sous la forme d'un parmi un contact enfichable, des connecteurs auto-dénudants, ou une connexion à sertir.
